# EUROPÄISCHE PATENTANMELDUNG

(11) **EP 2 852 060 A1**
(43) Veröffentlichungstag der Anmeldung: **25.03.2015**
(21) Anmeldenummer: 14178137.7
(22) Anmeldetag: 23.07.2014
(51) Int. Cl.: H03K 17/97

(54) **Pilzschalter**

(30) Priorität: 23.09.2013 DE 102013219071
(71) Anmelder: BITO-Lagertechnik Bittmann GmbH, 55590 Meisenheim (DE)
(72) Erfinder: Gassner, Okten, 55571 Odernheim (DE); Nothof, Christian, 55590 Meisenheim (DE)
(74) Vertreter: Richardt Patentanwälte PartG mbB

(57) **Zusammenfassung**

Die Erfindung betrifft einen Schalter (100) zur Detektion von auf einer Rollenbahn beförderbarem Stückgut (200), wobei der Schalter (100) ein Gehäuse (102) und einen durch das Stückgut (200) betätigbaren Kopf (104) aufweist, wobei der Kopf (104) verschiebbar am Gehäuse (102) über ein metallisches Befestigungselement (106) gelagert ist, wobei das Befestigungselement (106) am Kopf (104) fixiert ist, wobei der Kopf (104) gegenüber dem Gehäuse (102) durch eine Druckfeder (108) abgestützt ist, wobei am Gehäuse (102) ein induktiver Näherungsschaiter (120) zur Detektion der Bewegung des metallischen Befestigungselements (106) angeordnet ist.

## Beschreibung

Die Erfindung betrifft einen Schalter zur Detektion von auf einer Rollenbahn beförderbaren Stückguts sowie eine Rollenbahn mit einem solchen Schalter.

Rollenbahnen sind aus dem Stand der Technik bekannt und dienen der Beförderung von Stückgut. Rollenbahnen bestehen dabei aus einer Vielzahl nebeneinander angeordneten drehbarer Rollen, wobei zum Beispiel aufgrund des Schwungs des Stückguts, eines Antriebs der Rollen und/oder einer leicht abschüssigen Erstreckung der Rollenbahnen, ein gleiten des Stückguts über die Rollen und damit eine Beförderung ermöglicht wird. Rollenbahnen sind auch unter dem Begriff des Rollenförderers bekannt.

Stückgut, beispielsweise Kisten, Kartons oder Paletten, können über die Rollenbahn transportiert werden, um dadurch von einem Ort zum andern befördert zu werden.

Um nun den Transport von Fördergut oder Stückgut auf den Rollen zu steuern, ist aus dem Stand der Technik beispielsweise die Verwendung von Sensorbrücken bekannt. Hierzu offenbart die DE 10 2005 047 977 A1 eine Rollenbahn mit parallel zueinander angeordneten und durch einen Antrieb rotierbaren Rollen zum Transport von Fördergut und entlang einer Förderrichtung quer zu den Rollenachsen, wobei zwischen zwei Rollen eine quer zur Förderrichtung verlaufende Sensorbrücke mit zumindest einem Sensorelement zur Detektierung eines Förderguts vorgesehen ist.

Der Erfindung liegt die Aufgabe zugrunde, einen verbesserten Schalter zur Detektion des Vorhandenseins von Stückgut sowie eine verbesserte Rollenbahn zu schaffen.

Die der Erfindung zugrunde liegenden Aufgaben werden durch die Merkmale der unabhängigen Ansprüche gelöst. Bevorzugte Ausführungsformen der Erfindung sind in den abhängigen Ansprüchen angegeben.

Es wird ein Schalter zur Detektion von auf einer Rollenbahn beförderbarem Stückgut angegeben, wobei der Schalter ein Gehäuse und einen durch das Stückgut betätigbaren Kopf aufweist, wobei der Kopf über das Stückgut verschiebbar am Gehäuse über ein metallisches Befestigungselement gelagert ist, wobei das Befestigungselement am Kopf fixiert ist, wobei der Kopf gegenüber dem Gehäuse durch eine Druckfeder abgestützt ist, wobei am Gehäuse ein induktiver Näherungsschalter zur Detektion der Bewegung des metallischen Befestigungselements angeordnet ist.

Ausführungsformen der Erfindung könnten den Vorteil haben, dass aufgrund der kompakten Bauweise eine Integration des Schalters in bestehende Rollenbahnen einfach möglich ist. Durch die Verwendung eines induktiven Näherungsschalters ist außerdem gewährleistet, dass der Schalter nahezu wartungsfrei arbeitet. Eine Ermüdung mechanischer Kontakte ist nicht möglich, da aufgrund der Detektion der Bewegung des metallischen Befestigungselements über den induktiven Näherungsschalter auf mechanische Kontakte verzichtet werden kann. Der induktive Näherungsschalter stellt sicher, dass berührungslos das Vorhandensein oder NichtVorhandensein des metallischen Befestigungselements erfasst werden kann. Außerdem wird durch die beschriebene Bauform gewährleistet, dass eine vollständige Kapselung der stromführenden Komponenten des Schalters möglich ist - der induktive Näherungsschalter kann als eine gekapselte Baueinheit Verwendung finden, ohne dass hierzu ein elektrischer Kontakt zu anderen Komponenten des induktiven Näherungsschalters notwendig wäre.

Nach einer Ausführungsform der Erfindung ist die Verschiebbarkeit des Kopfes durch einen an dem Befestigungselement angeordneten Anschlag begrenzt, wobei der Anschlag zur Begrenzung der Verschiebbarkeit des Befestigungselements in Richtung zum Kopf hin gegenüber einer Anschlagfläche des Gehäuses ausgebildet ist. Die Druckfeder kann sich also am Gehäuse abstützen, um den Kopf aus dem Gehäuse herauszudrücken. Um diese Bewegung des Kopfes aus dem Gehäuse heraus zu begrenzen, ist nun der besagte Anschlag vorgesehen, welcher sich an einer Anschlagfläche des Gehäuses abstützt. Der Kopf kann sich also nun über eine durch Anschlag, Befestigungselement und Anschlagfläche vordefinierte Strecke vom Gehäuse entfernen.

Nach einer Ausführungsform der Erfindung weist das Gehäuse eine Stützfläche mit einer Bohrung auf, wobei das Befestigungselement in der Bohrung längsverschiebbar gelagert ist, wobei die Druckfeder zwischen der dem Kopf zugewandten Seite der Stützfläche und dem Kopf angeordnet ist. Dies könnte zum einen die Gesamtstabilität des Schalters erhöhen, da aufgrund der Längsverschiebbarkeit des Befestigungselements in der Bohrung eine seitliche Abstützung des Befestigungselements selbst gegeben ist. Wenn außerdem der Anschlag auf der dem Kopf abgewandten Seite der Stützfläche an dem Befestigungselement angeordnet ist, sodass durch die dem Kopf abgewandten Seite der Stützfläche die Anschlagfläche für den Anschlag gebildet wird, könnte gewährleistet sein, dass die auf das Gehäuse wirkenden Kräfte zentral an dieser Stützfläche angreifen. Es kommt also nicht zu Verziehungen innerhalb des Gehäuses, welche eine Betätigbarkeit des Schalters beeinträchtigen könnte.

Nach einer Ausführungsform der Erfindung ist der Anschlag rotationssymmetrisch zur Achse des Befestigungselements ausgebildet. Auch diese könnte unterstützen, dass sich auch nach einer Vielzahl von Schaltvorgängen das Gehäuse des Schalters nicht verzieht. Die über Anschlag und Feder auf das Gehäuse wirkenden Kräfte greifen gleichmäßig an der Stützfläche des Gehäuses an, sodass hier eine gleichmäßige Belastung gegeben ist und eine einseitige Belastung, welche das Verziehen des Gehäuses begünstigen könnte, vermieden wird.

Von Vorteil wäre hier auch, wenn beispielsweise die Druckfeder das Befestigungselement selbst umgibt.

Nach einer Ausführungsform der Erfindung handelt es sich bei dem Befestigungselement um eine Zylinderschraube, wobei der Anschlag durch den Kopf der Zylinderschraube gebildet wird. Neben einer einfachen Verfügbarkeit einer solchen Zylinderschraube und damit einer kostengünstigen Herstellbarkeit des Schalters könnte dies den Vorteil haben, dass aufgrund des vorliegenden Gewindes der Zylinderschraube diese in einfacher Weise in den Kopf einschraubbar ist, um damit den Kopf mit dem metallischen Befestigungselement fixiert zu verbinden. Weist der Kopf nach einer Vielzahl von Betätigungsvorgängen beispielsweise Beschädigungen an seiner dem Stückgut zugewandten Seite auf, so könnte damit ein einfacher Austausch des Kopfes durch Herausschrauben der Zylinderschraube ermöglicht werden. Vorzugsweise ist dazu der Schalter nach unten in Richtung weg vom Kopf offen, sodass mit einem entsprechenden Werkzeug wie einem Schraubenzieher die Zylinderschraube aus dem Kopf herausgedreht werden kann.

Nach einer Ausführungsform der Erfindung weist der Kopf eine seitliche Führung auf, wobei das Gehäuse eine Außenwand aufweist, wobei die Führung an einander gegenüberliegenden Seiten, gegebenenfalls auch schräg gegenüberliegenden Seiten des Kopfes eine senkrecht zur Erstreckungsrichtung des Befestigungselements wirkende Abstützung an der Außenwand bildet. Unabhängig von der Auftreffrichtung des Stückguts auf den Kopf ist damit gewährleistet, dass der Kopf in seiner Bewegung in Richtung zum Gehäuse und weg vom Gehäuse nicht beeinträchtigt ist und z.B. verkantet werden kann. Die Verschiebbarkeit des Kopfes ist damit unabhängig von der Auftreffrichtung des Stückguts auf den Kopf.

Vorzugsweise ist dabei wiederum die Führung rotationssymmetrisch zur Achse des Befestigungselements ausgebildet.

Außerdem weist zum Beispiel der Kopf eine innere Führung auf, wobei das Gehäuse eine Aussparung zur formschlüssigen Aufnahme der inneren Führung aufweist. Durch einen entsprechenden Formschluss in radialer Richtung zum Befestigungselement gesehen könnte auch dadurch weiter unterstützt werden, dass ein auf den Kopf wirkender Krafteintrag aufgrund eines darüber befindlichen Stückguts zu keinem Sich-Verkanten des Kopfes im Gehäuse führt.

Nach einer Ausführungsform der Erfindung ist auch vorzugsweise die innere Führung rotationssymmetrisch zum Befestigungselement geformt.

Nach einer weiteren Ausführungsform der Erfindung ist der Kopf pilzförmig. Dadurch ist es möglich, dass das Stückgut sanft auf den Kopf aufgleiten und diesen zur Betätigung nach unten drücken kann. Auch hier wiederum ist die Funktion des Schalters unabhängig von der Auftreffrichtung des Stückguts auf dem Kopf.

Nach einer Ausführungsform der Erfindung ist der induktive Näherungsschalter seitlich am Gehäuse angeordnet. Wie bereits oben erwähnt, könnte dies den Vorteil haben, dass damit der Zugang zum besagten Befestigungselement von unten auf der dem Kopf abgewandten Seite des Gehäuses problemlos möglich ist. Damit könnte ohne Beeinträchtigung des Schalters selbst ein Auswechseln des Befestigungselements möglich sein. Dies ist dabei unabhängig davon, ob es sich bei dem Befestigungselement um eine Zylinderschraube oder um eine speziell angefertigte Komponente eines metallischen Befestigungselements handelt.

Nach einer weiteren Ausführungsform der Erfindung ist in der unbetätigten Ruheposition des Schalters der induktive Näherungsschalter unmittelbar unterhalb des Anschlags angeordnet. Dadurch könnte es möglich sein, dass der Verschiebeweg des Kopfes minimal gehalten werden kann. Für eine minimale Verschiebung des Kopfes aufgrund einer Betätigung durch das Stückgut ist es möglich, das Vorhandensein des Stückguts zu detektieren.

In einem weiteren Aspekt betrifft die Erfindung eine Rollenbahn mit einem oben beschriebenen Schalter.

Im Weiteren werden bevorzugte Ausführungsformen der Erfindung anhand der nachfolgenden Zeichnungen näher erläutert. Es zeigen:
- Figur 1: eine Ansicht eines Schalters,
- Figur 2: eine perspektivische Ansicht einer Rollenbahn mit Schalter im unbetätigten Zustand,
- Figur 3: eine perspektivische Ansicht der Rollenbahn der Figur 2 mit einem Schalter im betätigten Zustand.

Im Folgenden werden einander ähnliche Elemente mit den gleichen Bezugszeichen gekennzeichnet.

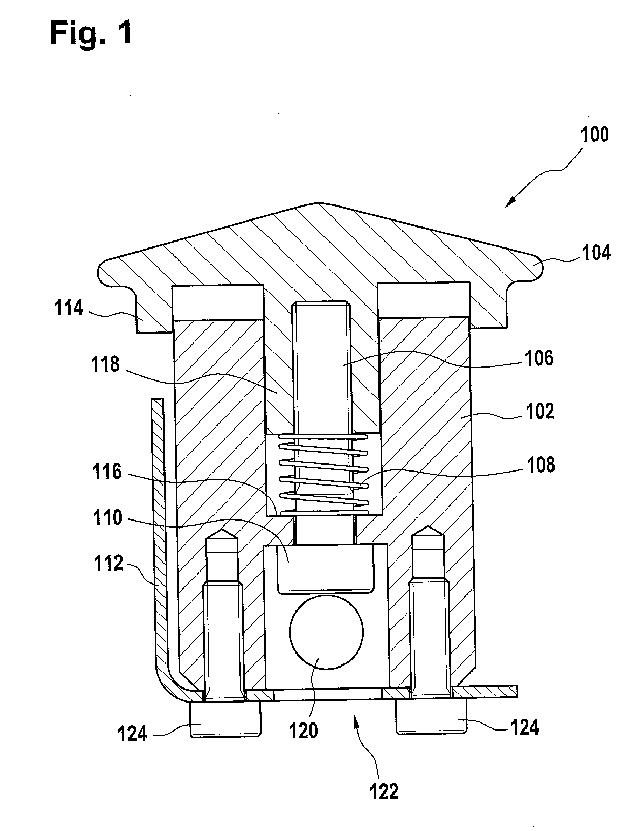

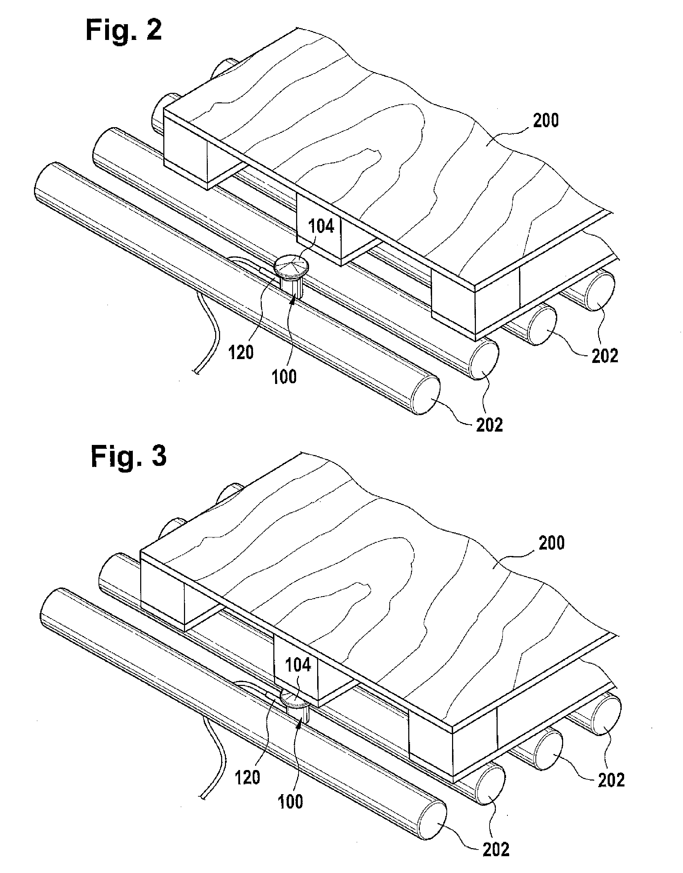

Die Figur 1 zeigt einen Schalter 100 zur Detektion von auf einer Rollenbahn beförderbarem Stückgut. Ein Teil der Rollenbahn ist dabei in Figur 2 gezeigt, wobei hier Laufrollen 202 ersichtlich sind, über welche eine Palette 200 befördert werden kann. Der Schalter 100 befindet sich zwischen zwei einander parallel benachbarten Laufrollen 202.

Der Schalter 100 weist einen Kopf 104 auf, welcher an einem Gehäuse 102 über ein metallisches Befestigungselement 106 beweglich gelagert ist. Das metallische Befestigungselement 106 ist dabei fest am Kopf 104 fixiert.

Eine Stützfläche 116 des Gehäuses 102 weist eine Bohrung auf, in welcher das metallische Befestigungselement 106 geführt ist. Eine Druckfeder 108 umgibt das metallische Befestigungselement 106 und ist zum einen an der Stützfläche 116 abgestützt und drückt zum anderen gegen den Kopf 104 von unten.

Dies führt dazu, dass im Ruhezustand der Kopf 104 ein Stück aus dem Gehäuse 102 nach oben abgehoben ist. Der Zustand ist auch in der Figur 2 gezeigt. Fährt nun das Stückgut 200 auf die pilzförmige Oberseite des Kopfes 104 auf, so wird, wie in der Figur 3 ersichtlich ist, der Kopf 104 entgegen der Kraft der Druckfeder 108 nach unten gedrückt. Dadurch wird das metallische Befestigungselement 106 aufgrund seiner starren Verbindung mit dem Kopf 104 ebenfalls nach unten bewegt.

Das metallische Befestigungselement 106 weist an seinem dem Kopf 104 abgewandten Ende einen zur Achse des Befestigungselements 106 vorzugsweise rotationssymmetrischen Anschlag 110 auf.

In dem Beispiel der Figur 1 handelt es sich bei dem Befestigungselement 106 um eine Zylinderkopfschraube, sodass durch den Zylinderkopf gleichzeitig auch der Anschlag 110 gebildet ist.

In dem in Figur 3 gezeigten Zustand wird also der Kopf 104 mitsamt der Schraube und deren Anschlag 110 nach unten gedrückt. Sobald das Stückgut den Kopf 104 nicht mehr betätigt und diesen nach unten drückt, wird aufgrund der zwischen Stützfläche 116 und Kopf 104 befindlichen Druckfeder 108 der Kopf 104 wiederum nach oben in seine Ausgangslage zurückgeschoben.

Um nun das Vorhandensein von Stückgut zu detektieren ist vorgesehen, dass ein induktiver Näherungsschalter 120 seitlich am Gehäuse 102 vorgesehen ist. Vorzugsweise ist dabei in der unbetätigten Ruheposition des Schalters der induktive Näherungsschalter 120 unmittelbar unterhalb des Anschlags 110 angeordnet. Der induktive Näherungsschalter ist in der Lage, die Bewegung des Kopfes 110 zu detektieren. Die Detektion erfolgt dabei berührungslos, sodass ein verschleißfreier Betrieb des Schalters 100 möglich ist.

Um bei einer Betätigung des Kopfes 104 ein Verkanten des Kopfes bezüglich des Gehäuses 102 zu vermeiden, sind mehrere Möglichkeiten vorgesehen: Zunächst ist das metallische Befestigungselement 106 zentriert zum Kopf 104 und auch zentriert zum Gehäuse 102 angeordnet. Des Weiteren ist vorgesehen, dass der Kopf eine in axialer Richtung des Befestigungselements sich erstreckende innere Führung 118 aufweist, welche rotationssymmetrisch das Befestigungselement 106 umgibt. Diese innere Führung 118 liegt formschlüssig an der Innenseite des Gehäuses 102 an. Die Innenseite des Gehäuses 102 bildet also eine Führung für die innere Führung 118 des Kopfes 104.

Des Weiteren weist der Kopf 104 seitliche Führungen 114 auf, welche einander gegenüberliegen. Einandergegenüberliegen kann hier sowohl ein axiales Einandergegenüberliegen bezüglich des Befestigungselements bedeuten als auch ein schräg zueinander versetztes Gegenüberliegen auf der gleichen Höhe, also in der Ansicht der Figur 1 auf einer gleichen horizontalen Ebene bedeuten. Diese seitlichen Führungen 114 liegen an der Außenwand des Gehäuses 102 an und bilden damit eine senkrecht zur Erstreckungsrichtung des Befestigungselements 106 wirkende Abstützung des Kopfes 104.

Vorzugsweise ist insgesamt der gesamte Aufbau des Schalters 100 rotationssymmetrisch zum Befestigungselement 106.

Wie ferner in der Figur 1 ersichtlich ist, ist das Gehäuse 102 nach unten auf seiner dem Kopf 104 abgewandten Seite 122 offen. Dadurch ist es möglich, mit einem entsprechenden Werkzeug den Anschlag 110 aus dem Kopf 104 herauszudrehen. Dadurch ist es möglich, den Kopf 104 im Falle einer Beschädigung auszuwechseln. Hierzu ist der Bewegungsweg des Anschlags 110 parallel zur Erstreckungsachse des Befestigungselements 106 frei von dem induktiven Näherungsschalter. Der induktive Näherungsschalter 120 ist also dem Anschlag 110 auch bei vollständigem Entfernen des Anschlags 110 aus dem Gehäuse nicht im Weg.

Der Schalter 100 ist über zwei Schrauben oder allgemein zwei Befestigungsmitteln 124 an einem Rahmenelement 112 der Rollenbahn befestigt.

### Bezugszeichenliste

- 100: Schalter
- 102: Gehäuse
- 104: Kopf
- 106: Befestigungselement
- 108: Druckfeder
- 110: Anschlag
- 114: Führung
- 116: Stützfläche
- 118: Führung
- 120: induktiver Näherungsschalter
- 122: Seite
- 124: Befestigungsmittel
- 200: Stückgut
- 202: Förderrolle

## Patentansprüche

1. Schalter (100) zur Detektion von auf einer Rollenbahn beförderbarem Stückgut (200), wobei der Schalter (100) ein Gehäuse (102) und einen durch das Stückgut (200) betätigbaren Kopf (104) aufweist, wobei der Kopf (104) verschiebbar am Gehäuse (102) über ein metallisches Befestigungselement (106) gelagert ist, wobei das Befestigungselement (106) am Kopf (104) fixiert ist, wobei der Kopf (104) gegenüber dem Gehäuse (102) durch eine Druckfeder (108) abgestützt ist, wobei am Gehäuse (102) ein induktiver Näherungsschalter (120) zur Detektion der Bewegung des metallischen Befestigungselements (106) angeordnet ist.

2. Schalter (100) nach Anspruch 1, wobei die Verschiebbarkeit des Kopfes (104) durch einen an dem Befestigungselement (106) angeordneten Anschlag (110) begrenzt ist, wobei der Anschlag (110) zur Begrenzung der Verschiebbarkeit des Befestigungselements (106) in Richtung zum Kopf (104) hin gegenüber einer Anschlagfläche des Gehäuses (102) ausgebildet ist.

3. Schalter (100) nach Anspruch 1 oder 2, wobei das Gehäuse (102) eine Stützfläche (116) mit einer Bohrung aufweist, wobei das Befestigungselement (106) in der Bohrung längsverschiebbar gelagert ist, wobei die Druckfeder (108) zwischen der dem Kopf (104) zugewandten Seite der Stützfläche (116) und dem Kopf (104) angeordnet ist.

4. Schalter (100) nach Anspruch 3, wobei der Anschlag (110) auf der dem Kopf (104) abgewandten Seite der Stützfläche (116) an dem Befestigungselement (106) angeordnet ist, wobei durch die dem Kopf (104) abgewandte Seite der Stützfläche (116) die Anschlagfläche für den Anschlag (110) gebildet wird.

5. Schalter (100) nach einem der vorigen Ansprüche, wobei der Anschlag (110) rotationssymmetrisch zur Achse des Befestigungselements (106) ausgebildet ist.

6. Schalter (100) nach Anspruch 5, wobei es sich bei dem Befestigungselement (106) um eine Zylinderschraube handelt, wobei der Anschlag (110) durch den Kopf (104) der Zylinderschraube gebildet wird.

7. Schalter (100) nach einem der vorigen Ansprüche, wobei die Druckfeder (108) das Befestigungselement (106) umgibt.

8. Schalter (100) nach einem der vorigen Ansprüche, wobei der Kopf (104) eine seitliche Führung (114) aufweist, wobei das Gehäuse (102) eine Außenwand aufweist, wobei die Führung (114) an einander gegenüberliegenden Seiten des Kopfes (104) eine senkrecht zur Erstreckungsrichtung des Befestigungselements (106) wirkende Abstützung an der Außenwand bildet.

9. Schalter (100) nach Anspruch 8, wobei die Führung (114) rotationssymmetrisch zur Achse des Befestigungselements (106) ausgebildet ist.

10. Schalter (100) nach einem der vorigen Ansprüche, wobei der Kopf (104) eine innere Führung (118) aufweist, wobei das Gehäuse (102) eine Aussparung zur formschlüssigen Aufnahme der inneren Führung aufweist.

11. Schalter (100) nach Anspruch 10, wobei die innere Führung (118) rotationssymmetrisch zum Befestigungselement (106) geformt ist.

12. Schalter (100) nach einem der vorigen Ansprüche, wobei der Kopf (104) pilzförmig ist.

13. Schalter (100) nach einem der vorigen Ansprüche, wobei der induktive Näherungsschalter (120) seitlich am Gehäuse (102) angeordnet ist

14. Schalter (100) nach Anspruch 13, wobei in der unbetätigten Ruheposition des Schalters (100) der induktive Näherungsschalter (120) unmittelbar unterhalb des Anschlags angeordnet ist.

15. Rollenbahn mit einem Schalter (100) nach einem der vorigen Ansprüche.
